(19) Europäisches Patentamt
European Patent Office
Office européen des brevets

(11) EP 4 464 478 B1

(12) EUROPEAN PATENT SPECIFICATION

(45) Date of publication and mention of the grant of the patent:
**05.08.2026 Bulletin 2026/32**

(21) Application number: **23174334.5**

(22) Date of filing: **19.05.2023**

(51) International Patent Classification (IPC):
***B26B 21/60*** *(2006.01)* ***B05D 1/00*** *(2006.01)*
***B05D 5/08*** *(2006.01)* ***B05D 7/00*** *(2006.01)*
***B26B 21/22*** *(2006.01)* ***B26B 21/40*** *(2006.01)*
***C23C 14/02*** *(2006.01)* ***C23C 14/06*** *(2006.01)*
***C23C 14/14*** *(2006.01)* ***C23C 14/34*** *(2006.01)*
***C23C 14/16*** *(2006.01)* ***C23C 16/02*** *(2006.01)*
***C23C 16/56*** *(2006.01)* *B05D 3/02 (2006.01)*
*B05D 3/04 (2006.01)* *B05D 7/14 (2006.01)*

(52) Cooperative Patent Classification (CPC):
**B05D 1/60; B05D 5/08; B05D 7/51; B26B 21/60; C23C 14/067; C23C 14/165; C23C 16/0281; C23C 16/56;** B05D 3/0254; B05D 3/0493; B05D 7/14; B05D 2202/15; B05D 2350/63; B05D 2350/65; B05D 2401/33

(54) **RAZOR BLADE COMPRISING A PARYLENE AND TITANIUM**

RASIERKLINGE MIT PARYLEN UND TITAN

LAME DE RASOIR COMPRENANT DU PARYLÈNE ET DU TITANE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**20.11.2024 Bulletin 2024/47**

(73) Proprietor: **BIC Violex Single Member S.A.**
**145 69 Anoixi (GR)**

(72) Inventors:
- **Pandis, Christos**
  **145 69 Anoixi (GR)**
- **Tsiakatouras, Georgios**
  **145 69 Anoixi (GR)**

(74) Representative: **Peterreins Schley**
**Patent- und Rechtsanwälte PartG mbB**
**Hermann-Sack-Straße 3**
**80331 München (DE)**

(56) References cited:
**US-A- 4 950 365**
**US-A- 5 869 135**
**US-A1- 2017 113 359**
**US-A1- 2020 316 803**
**US-A1- 2023 066 180**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 464 478 B1

## Description

### Technical Field

The present invention relates to the field of razor blades. More specifically, the present invention relates to razor blades comprising lubrication layers.

### Background

Razor heads (also known as safety razor heads, razor cartridges or safety razor cartridges) are usually part of a shaving razor assembly that includes a razor handle. A razor head typically comprises one or more cutting members, each including a razor blade, and being arranged between a leading longitudinal side and a trailing longitudinal side of the razor head. In use, a user holds the razor handle in a shaving direction and brings the razor head into contact with a portion of skin. By movement of the razor head in a shaving direction, unwanted hair is removed.

Razor blades for razor cartridges typically comprise a lubrication layer. As the lubrication layers are typically applied by coating, they may also be referred to as lubrication coatings. The lubrication layer is intended to reduce the required cutting force during the shaving process. By reducing the required cutting force, the razor may exhibit improved glide during the shaving action, which in turn would facilitate the razor's use. Additionally, reducing the required cutting force may result in lesser pulling on the hair and thereby hair follicles, which may result in discomfort to the user. Furthermore, the lubrication coating may also reduce the friction between the razor blade and the user's skin, which may also improve the razor's glide. Furthermore, the reduced required cutting force and improved glide may result in improved shaving result, e.g. less stubbles, nicks and cuts.

Typically, lubricating coatings for razor blades are made of a perfluoro- or a polyfluoroalkyl substance (PFAS) such as polytetrafluoroethylene (PTFE). PTFE coated razor blades are effective in cutting through hair, show little friction on the skin, as well as a low degree of pulling on the hair.

However, PTFE coatings may also experience drawbacks. First, PTFE coatings are typically applied by spraying PTFE particles onto a razor blade and subsequently sintering those particles at temperatures above the melting point of PTFE. The resulting coating may lack uniformity, which in turn may result in a reduced shaving performance of the razor blades. Further, the increased temperatures during the sintering step may reduce the hardness and corrosion resistance of the razor blade. Finally, PTFE is a highly persistent material and is therefore the subject of environmental concerns.

US 2020/316803 Al discloses a razor blade comprising a lubricating layer, which may also be a parylene. It discloses top layers as such on the razor blade improving adhesion of the polymer coating layer.

US 2017/113359 Al discloses a cutting blade of a first material optionally coated with a second material. In longer lists of the first and second materials, steel, titanium and parylene as such are mentioned, respectively.

US 4 950 365 A discloses a selective parylene coating as such and the example refers to a titanium adhesion layer on a gold substrate.

US 2023/066180 Al discloses parylene coatings on tools as such and mentions parylene C and parylene N singly as possibilities. The example covers a screwdriver, and the application is focused on the prevention of corrosion.

US 5 869 135 A discloses a shaving foil for an electric shaver coated with a parylene coating. The description names various types of parylene coatings, including parylene C and parylene N as single layers among a list of possibilities.

The present disclosure aims to address one or more of the aforementioned issues in optimizing lubrication layers.

### Summary

In a first aspect, the present disclosure relates to a razor blade provided with a first layer comprising titanium and a second layer comprising a parylene and wherein the razor blade comprises a cutting edge portion and wherein the first layer and second layer are provided on the cutting edge portion.

In some embodiments, the first layer may comprise the titanium as metallic titanium.

In some embodiments, the parylene may be selected from the group of Parylene-N, Parylene-C, Parylene-F and combinations thereof, and in particular the parylene may be selected from Parylene-N and/or Parylene-C.

In some embodiments, the razor blade may be configured to be disposed within a razor cartridge.

In some embodiments, the first layer may have a thickness between about 5 nm to about 70 nm, more specifically between about 10 nm to about 60 nm and in particular between about 20 nm to about 50 nm.

In some embodiments, the second layer may have a thickness between about 0.005 $\mu$m to about 5 $\mu$m, more specifically between about 0.02 $\mu$m to about 2 $\mu$m and in particular between about 0.1 $\mu$m to about 1 $\mu$m.

In some embodiments, the second layer may comprise no holes with a diameter of between about 5 nm to about 200 nm, in particular no holes.

In some embodiments, the second layer may comprise less than 1 wt.-%, more specifically less than 0.1 wt.-% and in particular no or substantially no polytetrafluoroethylene.

In some embodiments, the razor blade may be additionally provided with a hard coating.

In some embodiments, the hard coating may

comprise a ceramic, a metal and/or a non-metallic coating.

In some embodiments, the ceramic may comprise a boride and/or a carbide and in particular titanium diboride.

In some embodiments, the ceramic may comprise titanium, boron and carbon.

In some embodiments, the non-metallic coating may comprise diamond-like-carbon.

In some embodiments, the metal of the hard coating may comprise chromium.

In some embodiments, the first layer may be disposed between the hard coating and the second layer.

In some embodiments, the first layer may be provided directly on the razor blade. Alternatively, in some embodiments, the hard coating may be provided directly on the razor blade. Alternatively, in some embodiments, an intermediate layer may be provided on the razor blade and the hard coating may be provided on the intermediate layer. In some embodiments the intermediate layer may comprise a metal, more specifically niobium and/or titanium, even more specifically titanium and in particular metallic titanium.

In some embodiments, the razor blade may comprise, essentially consist or consist of a metal, in particular a stainless steel.

In some embodiments, the cross-section of the cutting edge portion may have a substantially symmetrical tapering geometry terminating in a blade tip, the cross-section may have a central longitudinal axis originating from the blade tip, and the cutting edge portion may have a thickness of between 1.5 μm and 2.4 μm measured at a distance of 5 μm along the central longitudinal axis from the blade tip.

In a second aspect, the present disclosure relates to a razor cartridge comprising at least one razor blade according to any preceding claim.

In a third aspect, the present disclosure relates to a method for coating a razor blade. The method comprises coating a razor blade with a first layer comprising titanium, preferably by physical vapor deposition, and coating the razor blade with a second layer comprising a parylene, preferably by chemical vapor deposition.

According to the present invention, coating the razor blade with titanium is performed prior to coating the razor blade with the parylene.

In some embodiments, coating the razor blade with the first layer comprising titanium may be performed by sputtering.

In some embodiments, coating the razor blade with the parylene by chemical vapor deposition may comprise sublimating a dimer of a parylene-precursor, pyrolyzing the sublimated dimer of a parylene-precursor to attain parylene-precursor monomers, and depositing the parylene-precursor monomers on the razor blade.

In some embodiments, sublimating the dimer of a parylene-precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a parylene-precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the parylene-precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, the method for coating a razor blade may further comprise an annealing step, in particular, the razor blade may be annealed at a temperature between about 300 °C to about 400 °C, more specifically at a temperature between about 330 °C to about 370 °C in an inert gas atmosphere, in particular after deposition of the parylene.

In some embodiments, the razor blade may be annealed for a duration between about 10 s to about 20 min, more specifically between about 1 min to about 5 min.

## Brief Description of the Figures

**Fig. 1** is a schematic drawing of a razor blade's edge portion in cross-sectional view, wherein a first layer and second layer are provided on the blade's edge portion.

**Fig. 2** is a schematic drawing of a razor blade's edge portion in cross-sectional view, wherein a first layer and second layer are provided on the blade's edge portion on top of a hard coating and an intermediate layer.

**Fig. 3** is a schematic drawing of a razor blade's edge portion in cross-sectional view, wherein a first sublayer and second sublayer are provided on the blade's edge portion on top of a first coating and a hard coating.

**Fig. 4** shows a comparison of the cutting force of the third sample lot and the first comparative sample lot.

**Fig. 5** shows a comparison of the cutting force of the first, second, third and fourth sample lot.

**Fig. 6** shows a comparison of the cutting force of the third sample lot and the fifth sample lot.

**Fig. 7** shows a comparison of the friction force of the second sample lot compared to a second **comparative** sample lot.

## Detailed Description

Hereinafter, a detailed description will be given of the present disclosure. The terms or words used in the description and the aspects of the present disclosure are not to be construed limitedly as only having common-language or dictionary meanings and should, unless specifically defined otherwise in the following description, be interpreted as having their ordinary technical meaning as established in the relevant technical field. The detailed description will refer to specific embodiments to better illustrate the present disclosure, however, it should be understood that the presented disclosure is not limited to these specific embodiments.

As mentioned above, typically lubricating coatings for razor blades are made of a perfluoro- or a polyfluoroalkyl substance (PFAS) such as polytetrafluoroethylene (PTFE), as PTFE coated razor blades are effective in cutting through hair, show little friction on the skin, as well as low pulling on the hair.

However, PTFE coatings may lack uniformity as a result of deposition by spraying particles, which in turn may result in a reduced shaving performance of the razor blades. Further, the increased temperatures (for prolonged times) during the sintering step may reduce the hardness and corrosion resistance of the razor blade. Additionally, PTFE is a highly persistent material and is therefore the subject of environmental concerns.

A currently emerging alternative to PTFE coatings (or any other PFAS coating) are coatings comprising polymers selected from the group of parylenes, which also show a low coefficient of friction. However, parylene coatings may lack adhesion to the razor blade.

It has been surprisingly found that by first depositing titanium on the razor blade and subsequently depositing parylene onto the razor blade, the adhesion of the parylene can be improved.

Accordingly, in a first aspect, the present disclosure relates to a razor blade provided with a first layer comprising titanium and a second layer comprising a parylene. The razor blade according to the first aspect exhibits a low cutting force. The cutting force is a measure for the amount of force required to cut through hair.

Thus, it has been surprisingly found, that additionally to resulting in an improved adhesion, the use of the first layer comprising titanium may result in a reduction in the required cutting force.

The adherence of PTFE coatings to the razor blade is typically enabled by using a chromium coating. However, is has been found that adhesion of parylene on chromium may be weak, which may result in an increase in the required cutting forces. The increase of the required cutting forces may result from the parylene coating being removed from the razor blade while shaving. The removal may occur already during the first shave when the parylene is provided on chromium, but may only gradually occur when the parylene is provided on titanium. It has been surprisingly found that by providing a layer of titanium, as opposed to chromium, for the parylene to adhere to, the required cutting force of the razor blade can be substantially reduced.

In some embodiments, the first layer may comprise the titanium as metallic titanium. Metallic titanium may be especially suited for the parylene to bind to it. The term "metallic titanium" is well known and i.a. attributed its common meaning in the art. Additionally or alternatively, the term "metallic titanium" may relate to a reduced state of titanium wherein its oxidation number is 0. Additionally or alternatively, the term "metallic titanium" may relate to the titanium atoms comprised in the first layer forming metallic bonds with one another. In some embodiments, the first layer may consist, or essentially consist of titanium (as detailed above).

In some embodiments, the parylene may be selected from the group of Parylene-N, Parylene-C, Parylene-F and combinations thereof. In particular, in some embodiments, the parylene may be selected from Parylene-N and/or Parylene-C. It has been surprisingly found that a second layer comprising Parylene-N may result in a reduced cutting force compared to other parylenes. However, a second layer comprising Parylene-C may result in a lower cutting force after multiple uses of the razor blade, compared to Parylene-N.

In some embodiments, the second layer may consist, or essentially consist of parylene (as detailed above).

The term "parylene" refers to a polymer whose backbone consists of para-benzenediyl rings - $C_6H_4$ connected by 1,2-ethanediyl bridges $-CH_2-CH_2-$. Substitution of the para-benzenediyl rings results in different types of parylenes.

Parylene-N (or parylene-N) is an un-substituted parylene. Parylene-N may be obtained by polymerization of para-xylylene. Parylene-N consists of the following repeating unit:

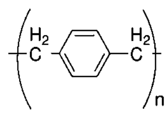

Parylene-C (or parylene-C) is a chlorinated-parylene. Parylene-C may be obtained by polymerization of 2,8-Dichlorotricyclo[8.2.2.24,7]hexadeca-1(12),4,6,10,13,15-hexaene. Parylene-C consists of the following repeating unit:

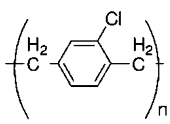

Parylene-F (or parylene-F) is a fluorinated-parylene, in particular wherein the four hydrogens on the aryl ring are substituted by fluorine. Parylene-F may be obtained by polymerization of 4,5,7,8,12,13,15,16-Octafluoro[2.2]paracyclophane. Parylene-F consists of the following repeating unit:

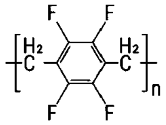

Additionally, it has been surprisingly found, that the combination of Parylene-C and Parylene-N results in a reduced cutting force compared to either a second layer comprising Parylene-C or Parylene-N. In particular, the second layer may comprise a first sublayer comprising Parylene-C and a second sublayer comprising Parylene-N. In some embodiments, the first sublayer comprising Parylene-C may be provided on the first layer and the second sublayer comprising Parylene-N may be provided on the first sublayer. In some alternative embodiments, the first sublayer may comprise Parylene N and the second sublayer may comprise Parylene C.

In some embodiments, the razor blade may comprise, essentially consist or consist of a metal, in particular a stainless steel. Stainless steel razor blades may exhibit high strength, hardness and corrosion resistance. Further, stainless steel razor blades may be easier to process compared to for example ceramic razor blades. The razor blade may have undergone grinding to form an edge. More specifically, the razor blade may be shaped such that it terminates in a cutting edge portion having substrate sides which converge towards a substrate edge. Accordingly, in some embodiments, the razor blade may comprise a cutting edge portion and the first layer and second layer may be provided on the cutting edge portion. As mentioned above, the second layer comprising the parylene may be configured to act as a lubrication coating. The lubrication coating may improve cutting of the hairs by the razor blade. Therefore, it may be beneficial to provide the first layer and second layer at least on the cutting edge portion.

When referring to a cutting edge portion which is provided with a first layer and a second layer, it should be understood that such reference does not merely refer to the strict geometrical edge of the razor blade but rather to the edge in view of the cutting action it performs. Accordingly, the term cutting edge portion is also meant to encompass those parts of the razor blade sides which are immediately adjacent to the strict geometrical edge of the cutting edge portion. In exemplary embodiments, the region forming the cutting edge portion extends away from the strict geometric edge of the cutting edge portion along a central longitudinal axis of the cutting edge portion for a distance of: about 5 μm or less, about 10 μm or less, about 15 μm or less, about 25 μm or less, about 50 μm or less, about 75 μm or less, about 100 μm or less, about 125 μm or less, about 150 μm or less, about 175 μm or less, or about 200 μm or less. The first layer and/or the second layer may generally follow the surface and contour of the underlying cutting edge portion. In particular, the second layer may form the outermost layer disposed on the razor blade. Accordingly, the second layer may form the blade's edge.

In some embodiments, the first layer may have a thickness between about 5 nm to about 70 nm, more specifically between about 10 nm to about 60 nm and in particular between about 20 nm to about 50 nm. In some embodiments, the second layer may have a thickness between about 0.005 μm to about 5 μm, more specifically between about 0.02 μm to about 2 μm and in particular between about 0.1 μm to about 1 μm.

In some embodiments, the razor blade may be configured to be disposed within a razor cartridge. The use of lubrication coatings, such as the second layer, may be particularly beneficial for razor blades used in razor cartridges.

In some embodiments, the razor blade may be additionally provided with a hard coating. The hard coating may improve the razor blades hardness, in turn increasing the blade's durability, in particular its useful life. In some embodiments, the hard coating may comprise a ceramic, a metal and/or a non-metallic coating. In some embodiments, the ceramic may comprise a boride and/or a carbide and in particular titanium diboride. In some embodiments, the ceramic may comprise titanium, boron and carbon. In some embodiments, the metal of the hard coating may comprise chromium. In some embodiments, the non-metallic coating may comprise diamond-like-carbon.

When referring to a hard coating, it should be understood that the coating as such may be harder than the coated cutting edge portion and/or that the coated cutting edge portion may be hardened in its entirety in comparison to an uncoated substrate portion. The hardness of the hard coating or coated cutting edge portion may be determined by using a nanoindenter. During the nanoindentation process, a hard tip whose properties (mechanical properties, geometry, tip radius etc.) are known, penetrates the hard coating sample to be analyzed. For example, a Berkovich tip may be used for the indentation tests. The load enforced on the indenter tip was increased as the tip penetrated further into the specimen until penetration depth of 50-100 nm was reached. At this point, the load was held constant for a period of time and then the indenter was removed. The area of the residual indentation in the sample was measured. The hardness **H** is defined as the maximum load $\mathbf{P_{max}}$ divided by the residual indentation area **A:**

$$H = \frac{Pmax}{A}$$

In some embodiments, the hard coating or the

cutting edge portion may exhibit a hardness between about 5 GPa to about 30 GPa, more specifically between about 10 GPa to about 20 GPa.

In some embodiments, the first layer may be disposed between the hard coating and the second layer. As mentioned above, the second layer may form the outer most layer provided on the razor blade. Accordingly, the first layer may be provided closer to the razor blade than the second layer and the hard coating may be disposed closer to the razor blade than the first layer.

In some embodiments, the first layer may be provided directly on the razor blade. In this case the razor blade may not comprise a hard coating.

Alternatively, in some embodiments, the hard coating may be provided directly on the razor blade. In particular a hard coating comprising, essentially consisting or consisting of a metal, in particular chromium, may be disposed directly on the razor blade.

Some hard coatings, in particular hard coatings comprising a ceramic, may exhibit improved adhesion to the razor blade, when an intermediate layer binds the hard coating to the razor blade. Accordingly, in some embodiments, an intermediate layer may be provided on the razor blade and the hard coating may be provided on the intermediate layer. In some embodiments, the intermediate layer comprises titanium and/or niobium, more specifically titanium and in particular metallic titanium.

Fig. 1 shows the cutting edge portion 100 of a first exemplary razor blade 10 according to the first aspect. On the cutting edge portion 100, a first layer 102 comprising titanium is provided. A second layer 104 comprising a parylene is provided on the first layer 102, in particular as the outer most layer provided on the razor blade 10.

Fig. 2 shows the cutting edge portion 200 of a second exemplary razor blade 20 according to the first aspect. On the cutting edge portion 200, an intermediate layer 206 is provided, on which a hard coating 208 is provided. The hard coating 208 of the exemplary razor blade 20 may be in particular a ceramic. On the hard coating 208, a first layer 202 comprising titanium is provided. A second layer 204 comprising a parylene is then provided on the first layer 202, in particular as the outer most layer.

Fig. 3 shows the cutting edge portion 300 of a third exemplary razor blade 30 according to the first aspect. On the cutting edge portion 300, a hard coating 308 is directly provided. Some hard coatings, for example chromium, may not require an intermediate layer. On the hard coating 300, a first layer 302 comprising titanium is provided. On the first layer 302, a first sublayer 304a comprising Parylene-C is provided and thereon a second sublayer 304b comprising Parylene-N.

As will be explained in more detail below, the first layer and second layer can be applied by thin film deposition technologies. In particular, the first layer may be deposited by physical vapor deposition. In addition, the second layer may be deposited by chemical vapor deposition. As a result, the first layer and second layer can be applied to relatively small blade edge portions. In particular, the first layer and the second layer may be applied to smaller blade edge portions compared to conventional PTFE coatings prepared by spraying. Smaller blade edge portions may reduce the cutting force needed during the shaving action. Accordingly, in some embodiments, the cross-section of the cutting edge portion may have a substantially symmetrical tapering geometry terminating in a blade tip, the cross-section may have a central longitudinal axis originating from the blade tip, and the cutting edge portion may have a thickness of between 1.5 μm and 2.4 μm measured at a distance of 5 μm along the central longitudinal axis from the blade tip. In some embodiments, the blade's edge portion has a thickness of between about 4.6 μm and about 6.8 μm, in particular about 4.62 to about 6.74 μm, measured at a distance of about 20 μm along the central longitudinal axis from the blade tip. In some embodiments, the blade's edge portion has a thickness of between about 10.3 μm and 14.4 μm, in particular about 10.32 to about 14.35 μm, measured at a distance of about 50 μm along the central longitudinal axis from the blade tip. In some embodiments, the blade's edge portion has a thickness of between about 19.8 μm and 27.6 μm, in particular about 19.82 to about 27.52 μm, measured at a distance of about 100 μm along the central longitudinal axis from the blade tip.

The above-described razor blades can be manufactured by any suitable means. More specifically, the preparation and grinding of the blade substrate can be performed by any suitable means, for instance as disclosed in US 2017/136641 A1 which is incorporated by reference in its entirety.

In some embodiments, the second layer may comprise less than 1 wt.-%, more specifically less than 0.1 wt.-% and in particular no or substantially no polytetrafluoroethylene (PTFE) or any other perfluoro- or a polyfluoroalkyl substance (PFAS). As mentioned above, the second layer comprising the parylene may be used to replace lubrication coatings comprising PTFE (or any other PFAS). Further, as mentioned above, the first layer and second layer can be applied by thin film deposition technologies, as opposed to PTFE coatings which require a spraying step. Thin film deposition technologies may allow depositing layers of greater uniformity compared to spraying. Additionally, thin film deposition technologies may allow depositing layer with less defects compared to spraying. Accordingly, in some embodiments, the second layer may comprise no holes, in particular no holes with a diameter of between about 5 nm to about 200 nm.

In a second aspect, the present disclosure relates to a razor cartridge comprising at least one razor blade as described above. As mentioned above, the lubrication coating provided by the second layer may be in particular beneficial for razor blades for razor cartridges.

In a third aspect, the present disclosure relates to a method for coating a razor blade. The method comprises coating a razor blade with a first layer comprising titanium, more specifically by physical vapor deposition, and coating the razor blade with a second layer comprising a parylene, more specifically by chemical vapor deposition.

In some embodiments, coating the razor blade with titanium may be performed prior to coating the razor blade with the parylene. Accordingly, the parylene may be deposited on the titanium, whereby adhesion of the parylene to the razor blade is improved.

In some embodiments, coating the razor blade with a first layer comprising titanium may be performed by sputtering. In some embodiments, coating the razor blade with a first layer comprising titanium may be performed by in particular, DC Sputtering, RF Sputtering, Closed Field Unbalanced Magnetron Sputtering (CFUMS), Ion Beam Sputtering, Cathodic Arc Deposition, and High-Power Impulse Magnetron Sputtering (HiPIMS) using sintered titanium targets in an Ar atmosphere.

Examples of a CVD technology include Low Pressure CVD (LPCVD), Atmospheric Pressure CVD (APCVD), Atomic Layer Deposition (ALD), and Metalorganic CVD (MOCVD) using precursors. In some embodiments, coating the razor blade with the parylene by chemical vapor deposition may comprise the steps of sublimating a dimer of a parylene-precursor, pyrolyzing the sublimated dimer of a parylene-precursor to attain parylene-precursor monomers, and depositing the parylene-precursor monomers on the razor blade, in particular such that the parylene-precursor monomers polymerize. The parylene-precursor monomers may polymerize on the razor blade during or following the deposition. The polymerization of the parylene-precursor monomers may lead to the formation of a parylene layer. In case the second layer comprises a first sublayer comprising a first parylene such as Parylene-C and a second sublayer comprising a second parylene such as Parylene-N, the above steps of chemical vapor deposition (sublimation, pyrolysis and deposition) may be carried out individually for each sublayer.

In some embodiments, sublimating the dimer of a parylene-precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a parylene-precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the parylene-precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, the method may comprise a film-growth step following the deposition of the parylene precursor monomers, wherein the film-growth step is performed at a temperature of between about 50 °C to about 100°C, more specifically between about 60 °C to about 80 °C, and/or at a pressure of between about 0.0001 Torr to about 0.05 Torr, more specifically between about 0.0005 Torr to about 0.002 Torr. The film-growth step may improve the polymerization of the parylene-precursor monomers deposited on the razor blade.

In some embodiments, the method for coating a razor blade may further comprise an annealing step. In this case, the razor blade may be annealed at a temperature between about 300 °C to about 400 °C, more specifically at a temperature between about 330 °C to about 370 °C in an inert gas atmosphere, in particular after deposition of the parylene, or if performed, after the film-growth step. In some embodiments, the razor blade may be annealed for a duration between about 10 s to about 20 min, more specifically between about 1 min to about 5 min. If the annealing exceeds 20 minutes, the hardness and/or corrosion resistance of the razor blades may degrade. In some embodiments, the razor blade may be annealed in an inert atmosphere, more specifically a nitrogen or argon atmosphere. The annealing step may allow to reduce the required cutting force during the shaving action. Without wishing to be bound by theory, it is believed that the annealing step may increase the crystallinity of the parylene, which may result in an increased strength of the parylene, which in turn may reduce the required cutting force. Further, the softening of the parylene during the annealing step may also further increase the uniformity of the second layer. The annealing step may reduce the surface defects in the second layer, e.g. reduce its porosity.

As mentioned above, a hard coating may be provided on the razor blade. Accordingly, the razor blade may be coated with a hard coating, in particular prior to being coated with the fist layer. The razor blade may be coated with a hard coating for example using chemical vapor deposition or physical vapor deposition process. Exemplary hard coating deposition processes are described in US 2018/215056 A1 and US 10,442,098 B2, both of which are incorporated by reference in their entirety.

As mentioned above, an intermediate layer may be provided on the razor blade. Accordingly, the razor blade may be coated with an intermediate layer, in particular prior to being coated with the hard coating. The razor blade may be coated with the intermediate layer similar to the method of coating the razor blade with the first layer. Accordingly, in some embodiments, coating the razor blade with the intermediate layer, in particular an intermediate layer comprising titanium, may be performed by sputtering. In some embodiments, coating the razor blade with an intermediate layer may be performed by in particular, DC Sputtering, RF Sputtering, Closed Field Unbalanced Magnetron Sputtering (CFUMS), Ion Beam Sputtering, Cathodic Arc Deposition, and High-Power Impulse Magnetron Sputtering (HiPIMS) using sintered metal targes, in particular sintered titanium targets, in an Ar atmosphere.

**Experimental Section**

**Sample Preparation**

Five different sample lots (first, second, third, fourth and fifth sample lots) according to the first aspect were prepared. Furthermore, a first comparative sample lot and a second comparative sample lot not according to the first aspect were prepared as well.

**1. First Sample Lot (Titanium+Parylene-C)**

The first sample lot according to the first aspect comprises a first layer comprising titanium and a second layer comprising Parylene-C. The first sample lot was prepared by the following protocol:
Ten stainless steel razor blades were stacked on blade carriers in a rotating fixture of a depositing chamber. The depositing chamber comprised a titanium target and a $TiB_2$ target. In case a chromium layer was also deposited, e.g. as a capping layer, the depositing chamber also comprised a chromium target.

A preparative sequence of steps was carried out before the deposition of the intermediate layer, to perform a sputter etching. The depositing chamber was evacuated up to a base pressure of 10-5 Torr using vacuum means. Then Ar gas was inserted from an Ar gas source into the chamber up to a pressure of 8 mTorr (8.10-3 Torr). The loaded bayonets were rotated in the rotating fixture at a constant speed of 6 rpm using a motor, all targets, and notably the Ti and $TiB_2$ targets were operated under DC current control at 0.2 Amps. A DC voltage of 200-600 V was applied on the stainless steel blades for 4 minutes. The sputter etching step aids in removing impurities from the blade substrates and the targets through bombardment of Argon ions.

Subsequently, the coating process itself was carried out.

In a first sequence of steps for the formation of an intermediate layer, the chamber pressure was adjusted to 3 mTorr. The Ti and $TiB_2$ target(s) were operated under DC current control at 3 and 0.2 Amps respectively while a DC voltage of 0-50 V was applied on the rotating blades. Adjusting the deposition time, a Ti layer of 20-40 nm was deposited on the edge of the blade samples.

In a second sequence of steps, a $TiB_2$ hard coating was deposited, after the deposition of the Ti interlayer. The hard coating deposition also took place at pressure of 3mTorr. The Ti, Cr (if present), and $TiB_2$ targets were operated simultaneously, with the current on the Cr and Ti target set to 0.2 Amps, and the current on $TiB_2$ target set to 3 Amps. The current on the Ti and Cr target was used to prevent elements from depositing on that target. A DC bias voltage of 150 to 350 V was applied on the rotating blades. Adjusting the deposition time, a $TiB_2$ layer of 150-300 nm was deposited on the Ti layer.

In a third sequence a first layer was deposited on the hard coating. The first layer was also deposited at a pressure of 3 mTorr. The titanium target was operated under DC current control at 3-10 Amps while a DC voltage of 0-50 V was applied on the rotating blades. Adjusting the deposition time, a titanium layer with a thickness of 20-40 nm was deposited on the razor blades.

In a fourth sequence of steps for the formation of the second layer, the rotating fixture was transferred to a second deposition chamber comprising a vaporizer, a pyrolysis chamber, a deposition chamber, a cold trap and a mechanical vacuum pump. Subsequently, the second chamber was evacuated up to a base pressure of 1 Torr. Parylene-C-precursor dimers were vaporized at a temperature of 175 °C. Subsequently, the pressure in the chamber was reduced to 0.5 Torr and the Parylene-C-precursor-dimers pyrolyzed to form Parylene-C-precursor-monomers at a temperature of 680 °C. Subsequently, the formed Parylene-C-precursor-monomers were deposited at a temperature of 25 °C at a pressure of 0.1 Torr. The temperature was then raised to 70 °C at a pressure of 0.001 Torr.

In a fifth sequence of steps to anneal the razor blades the second chamber was filled with argon at atmospheric pressure and heated to a temperature of 350 °C for 10 minutes to anneal the razor blades. After cooling to room temperature, the finished razor blades according to the first aspect were removed from the second chamber.

**2. Second Sample Lot (Titanium+Parylene-N)**

The second sample lot according to the first aspect was prepared analogously to the first sample lot, except that Parylene-N-precursor-dimers were used as opposed to Parylene-C-precursor-dimers in the fourth sequence of steps.

**3. Third Sample Lot (Titanium+Parylene-C+Parylene-N)**

The third sample lot according to the first aspect was prepared analogously to the first sample lot, except that after deposition of the Parylene-C, the fourth sequence of steps was repeated using Parylene-N-precursor-dimers to deposit a first sublayer comprising Parylene-C and a second sublayer comprising Parylene-N.

**4. Fourth Sample Lot (Titanium+Parylene-F)**

The fourth sample lot was prepared analogously to the first sample lot, except that Parylene-F-precursor-dimers were used as opposed to Parylene-C-precursor-dimers in the fourth sequence of steps.

**5. Fifth Sample Lot (Titanium+Parylene-C+Parylene-N - no annealing)**

A fifth sample lot was prepared by coating the razor blades the same as for the third sample lot, however, the fifth sequence of steps was not performed. Hence, the fifth sample lot was not annealed.

**6. First Comparative Sample Lot (Chromium+Parylene-C+Parylene-N)**

A first comparative sample lot was prepared analogously to the first sample lot but by coating the razor blades with chromium instead of titanium in the third sequence of steps.

**7. Second Comparative Sample Lot (Chromium)**

A second comparative sample lot was prepared. The second comparative sample lot underwent the first sequence of step and second sequence of steps. Further, the second comparative sample lot underwent the third sequence of steps, however, it was coated with chromium instead of titanium. The second comparative sample lot did not undergo the fourth sequence of steps or fifth sequence of steps.

**Cutting Force Experiment**

The cutting force of the first, second, third, fourth and fifth sample lot, as well as of the first comparative sample lot, were determined.

Ten blades per sample lot were each subjected to 10 consecutive cuts on a moving wool felt. The blades were placed individually in a holder connected to a load cell. The load cell was used to measure the load on the blade during the cutting action.

In the following the test results are presented in the Figures 4 to 6, which are labelled as follows. The "Y"-Axis shows the required cutting force in "kg", the "X"-Axis denotes the number of cuts. The first sample lot is denoted by the letter "A", the second sample lot is denoted by the letter "B", the third sample lot is denoted by the letter "D", the fourth sample lot is denoted by the letter "C" and the fifth sample lot is denoted by the letter "E". The first comparative sample lot is denoted by the letter "F".

**Fig. 4** shows a comparison of the cutting force of the third sample lot and the first comparative sample lot. As shown in Fig. 4, the razor blades comprising the first layer comprising titanium exhibit a significantly reduced cutting force compared to the razor blades comprising the first layer comprising chromium.

**Fig. 5** shows a comparison of the cutting force of the first, second, third and fourth sample lots. As shown in Fig. 5, the razor blades comprising a second layer comprising Parylene-N (second sample lot) exhibit a lower cutting force during the first cuts, however, the required cutting force increases with the number of cuts, until it is higher than that of the Parylene-C coated blades (first sample lot). On the other hand, the Parylene-C coated blades (first sample lot) exhibit a higher required cutting force during the first use. The razor blades coated by a first sublayer comprising Parylene-C and a second sublayer comprising Parylene-N (third sample lot) outperform the first and second sample lots during all 10 cuts. The razor blades comprising a second layer comprising Parylene-F (fourth sample lot) exhibit a consistently higher cutting force compared to the other parylenes.

**Fig. 6** shows a comparison of the cutting force of the third sample lot and the fifth sample lot. As shown in Fig. 6 the annealed razor blades exhibit a significantly reduced cutting force compared to the non-annealed razor blades.

**Fig. 7** shows a comparison of the friction force in the unit "grams" (Y-Axis) of the second sample lot "B" compared to the second comparative sample lot "G". The X-axis shows the travelled distance over the paper in millimeters. For this test, the felt was exchanged with a cellulose paper. One razor blade of the second sample lot was placed parallel to the paper and the paper was allowed to move and the friction force was measured over the travelled distance. The test was then repeated for the second comparative sample lot. As shown in Fig. 7 the friction force of the second sample lot is significantly lower compared to the second comparative sample lot.

**Claims**

1. A razor blade (10, 20, 30) **characterized in that** it is provided with a first layer (102, 202, 302) comprising titanium and a second layer (104, 204, 304a and 304b) comprising a parylene and wherein the razor blade (10, 20, 30) comprises a cutting edge portion (100, 200, 300) and wherein the first layer (102, 202, 302) and second layer (104, 204, 304a and 304b) are provided on the cutting edge portion (100, 200, 300).

2. The razor blade (10, 20, 30) according to claim 1, wherein the first layer (102, 202, 302) comprises the titanium as metallic titanium.

3. The razor blade (10, 20, 30) according to any preceding claim, wherein the parylene is selected from the group of Parylene-N, Parylene-C, Parylene-F and combinations thereof, and in particular wherein the parylene is selected from Parylene-N and/or Parylene-C.

4. The razor blade (10, 20, 30) according to any preceding claim, wherein the razor blade (10, 20, 30) is configured to be disposed within a razor cartridge.

**5.** The razor blade (10, 20, 30) according to any preceding claim, wherein the first layer (102, 202, 302) has a thickness between about 5 nm to about 70 nm, more preferably between about 10 nm to about 60 nm and in particular between about 20 nm to about 50 nm.

**6.** The razor blade (10, 20, 30) according to any preceding claim, wherein the second layer (104, 204, 304a and 304b) has a thickness between about 0.005 μm to about 5 μm, more preferably between about 0.02 μm to about 2 μm and in particular between about 0.1 μm to about 1 μm.

**7.** The razor blade according (10, 20, 30) to any preceding claim, wherein the second layer (104, 204, 304a and 304b) comprises no holes with a diameter of between about 5 nm to about 200 nm, in particular no holes.

**8.** The razor blade (10, 20, 30) according to any preceding claim, wherein the second layer (104, 204, 304a and 304b) comprises less than 1 wt.-%, more preferably less than 0.1 wt.-% and in particular no or substantially no polytetrafluoroethylene.

**9.** The razor blade (10, 20, 30) according to any preceding claim, wherein the razor blade (10, 20, 30) is additionally provided with a hard coating (208, 308), wherein the hard coating (208, 308) comprises a ceramic, a metal and/or a non-metallic coating.

**10.** The razor blade (10, 20, 30) according to claim 9, wherein the first layer (102, 202, 302) is disposed between the hard coating (208, 308) and the second layer (104, 204, 304a and 304b).

**11.** The razor blade (10, 20, 30) according to any one of claims 9 or 10, wherein the first layer (102, 202, 302) is provided directly on the razor blade(10, 20, 30);

or wherein the hard coating (208, 308) is provided directly on the razor blade(10, 20, 30);
or wherein an intermediate layer is provided on the razor blade (10, 20, 30) and the hard coating (208, 308) is provided on the intermediate layer, more preferably wherein the intermediate layer comprises niobium or titanium, and in particular wherein the intermediate layer comprises metallic titanium.

**12.** The razor blade (10, 20, 30) according to any preceding claim, wherein the razor blade (10, 20, 30) comprises, essentially consists or consists of a metal, in particular a stainless steel.

**13.** A razor cartridge comprising at least one razor blade (10, 20, 30) according to any preceding claim.

**14.** A method for coating a razor blade (10, 20, 30), wherein the method is **characterized in that** it comprises:

- coating a razor blade (10, 20, 30) with a first layer (102, 202, 302) comprising titanium, more preferably by physical vapor deposition, and
- coating the razor blade (10, 20, 30) with a second layer (104, 204, 304a and 304b) comprising a parylene, more preferably by chemical vapor deposition.

**Patentansprüche**

**1.** Rasierklinge (10, 20, 30) **dadurch gekennzeichnet, dass** sie mit einer ersten Schicht (102, 202, 302), umfassend Titan, und einer zweiten Schicht (104, 204, 304a und 304b), umfassend ein Parylen, versehen ist und wobei die Rasierklinge (10, 20, 30) einen Schneidkantenabschnitt (100, 200, 300) umfasst und wobei die erste Schicht (102, 202, 302) und zweite Schicht (104, 204, 304a und 304b) auf dem Schneidkantenabschnitt (100, 200, 300) bereitgestellt sind.

**2.** Rasierklinge (10, 20, 30) nach Anspruch 1, wobei die erste Schicht (102, 202, 302) das Titan als metallisches Titan umfasst.

**3.** Rasierklinge (10, 20, 30) nach einem der vorstehenden Ansprüche, wobei das Parylen ausgewählt ist aus der Gruppe von Parylen-N, Parylen-C, Parylen-F und Kombinationen davon, und insbesondere wobei das Parylen ausgewählt ist aus Parylen-N und/oder Parylen-C.

**4.** Rasierklinge (10, 20, 30) nach einem der vorstehenden Ansprüche, wobei die Rasierklinge (10, 20, 30) konfiguriert ist, um in einer Rasierkartusche angeordnet zu sein.

**5.** Rasierklinge (10, 20, 30) nach einem der vorstehenden Ansprüche, wobei die erste Schicht (102, 202, 302) eine Dicke zwischen etwa 5 nm bis etwa 70 nm aufweist, mehr bevorzugt zwischen etwa 10 nm bis etwa 60 nm und insbesondere zwischen etwa 20 nm bis etwa 50 nm.

**6.** Rasierklinge (10, 20, 30) nach einem der vorstehenden Ansprüche, wobei die zweite Schicht (104, 204, 304a und 304b) eine Dicke zwischen etwa 0,005 μm bis etwa 5 μm aufweist, mehr bevorzugt zwischen etwa 0,02 μm bis etwa 2 μm und insbesondere zwischen etwa 0,1 μm bis etwa 1 μm.

**7.** Rasierklinge (10, 20, 30) nach einem der vorstehenden Ansprüche, wobei die zweite Schicht (104, 204,

304a und 304b) keine Löcher mit einem Durchmesser von etwa 5 nm bis etwa 200 nm umfasst, insbesondere keine Löcher.

**8.** Rasierklinge (10, 20, 30) nach einem der vorstehenden Ansprüche, wobei die zweite Schicht (104, 204, 304a und 304b) weniger als 1 Gew.-%, mehr bevorzugt weniger als 0,1 Gew.-% und insbesondere kein oder im Wesentlichen kein Polytetrafluorethylen umfasst.

**9.** Rasierklinge (10, 20, 30) nach einem der vorstehenden Ansprüche, wobei die Rasierklinge (10, 20, 30) zusätzlich mit einer harten Beschichtung (208, 308) versehen ist, wobei die harte Beschichtung (208, 308) eine keramische, eine metallische und/oder eine nichtmetallische Beschichtung umfasst.

**10.** Rasierklinge (10, 20, 30) nach Anspruch 9, wobei die erste Schicht (102, 202, 302) zwischen der harten Beschichtung (208, 308) und der zweiten Schicht (104, 204, 304a und 304b) angeordnet ist.

**11.** Rasierklinge (10, 20, 30) nach einem der Ansprüche 9 oder 10, wobei die erste Schicht (102, 202, 302) direkt auf der Rasierklinge (10, 20, 30) bereitgestellt ist;
oder wobei die harte Beschichtung (208, 308) direkt auf der Rasierklinge (10, 20, 30) bereitgestellt ist; oder wobei eine Zwischenschicht auf der Rasierklinge (10, 20, 30) bereitgestellt ist und die harte Beschichtung (208, 308) auf der Zwischenschicht bereitgestellt ist, mehr bevorzugt wobei die Zwischenschicht Niob oder Titan umfasst, und insbesondere wobei die Zwischenschicht metallisches Titan umfasst.

**12.** Rasierklinge (10, 20, 30) nach einem der vorstehenden Ansprüche, wobei die Rasierklinge (10, 20, 30) ein Metall umfasst, im Wesentlichen daraus besteht oder daraus besteht, insbesondere Edelstahl.

**13.** Rasierkartusche, umfassend mindestens eine Rasierklinge (10, 20, 30) nach einem der vorstehenden Ansprüche.

**14.** Verfahren zum Beschichten einer Rasierklinge (10, 20, 30), wobei das Verfahren **dadurch gekennzeichnet ist, dass** es umfasst:

- Beschichten einer Rasierklinge (10, 20, 30) mit einer ersten Schicht (102, 202, 302), umfassend Titan, mehr bevorzugt durch physikalische Gasphasenabscheidung, und
- Beschichten der Rasierklinge (10, 20, 30) mit einer zweiten Schicht (104, 204, 304a und 304b), umfassend ein Parylen, mehr bevorzugt durch chemische Gasphasenabscheidung.

## Revendications

**1.** Lame de rasoir (10, 20, 30) **caractérisée en ce qu'**elle est pourvue d'une première couche (102, 202, 302) comprenant du titane et d'une seconde couche (104, 204, 304a et 304b) comprenant un parylène et dans laquelle la lame de rasoir (10, 20, 30) comprend une partie de bord de coupe (100, 200, 300) et dans laquelle la première couche (102, 202, 302) et la seconde couche (104, 204, 304a et 304b) sont prévues sur la partie de bord de coupe (100, 200, 300).

**2.** Lame de rasoir (10, 20, 30) selon la revendication 1, dans laquelle la première couche (102, 202, 302) comprend du titane en tant que titane métallique.

**3.** Lame de rasoir (10, 20, 30) selon l'une quelconque revendication précédente, dans laquelle le parylène est choisi parmi le groupe de parylène-N, parylène-C, parylène-F et combinaisons de ceux-ci, et en particulier dans laquelle le parylène est choisi parmi parylène-N et/ou parylène-C.

**4.** Lame de rasoir (10, 20, 30) selon l'une quelconque revendication précédente, dans laquelle la lame de rasoir (10, 20, 30) est conçue pour être disposée à l'intérieur d'une cartouche de rasoir.

**5.** Lame de rasoir (10, 20, 30) selon l'une quelconque revendication précédente, dans laquelle la première couche (102, 202, 302) a une épaisseur comprise entre environ 5 nm et environ 70 nm, plus préférablement entre environ 10 nm et environ 60 nm et en particulier entre environ 20 nm et environ 50 nm.

**6.** Lame de rasoir (10, 20, 30) selon l'une quelconque revendication précédente, dans laquelle la seconde couche (104, 204, 304a et 304b) a une épaisseur comprise entre environ 0,005 $\mu$m et environ 5 $\mu$m, plus préférablement entre environ 0,02 $\mu$m et environ 2 $\mu$m et en particulier entre environ 0,1 $\mu$m et environ 1 $\mu$m.

**7.** Lame de rasoir (10, 20, 30) selon l'une quelconque revendication précédente, dans laquelle la seconde couche (104, 204, 304a et 304b) ne comprend aucun trou d'un diamètre compris entre environ 5 nm et environ 200 nm, en particulier aucun trou.

**8.** Lame de rasoir (10, 20, 30) selon l'une quelconque revendication précédente, dans laquelle la seconde couche (104, 204, 304a et 304b) comprend moins de 1 % en poids, plus préférablement moins de 0,1 % en poids et en particulier pas ou sensiblement pas de polytétrafluoroéthylène.

**9.** Lame de rasoir (10, 20, 30) selon l'une quelconque

revendication précédente, dans laquelle la lame de rasoir (10, 20, 30) est en outre pourvue d'un revêtement dur (208, 308), dans laquelle le revêtement dur (208, 308) comprend une céramique, un métal et/ou un revêtement non métallique.

**10.** Lame de rasoir (10, 20, 30) selon la revendication 9, dans laquelle la première couche (102, 202, 302) est disposée entre le revêtement dur (208, 308) et la seconde couche (104, 204, 304a et 304b).

**11.** Lame de rasoir (10, 20, 30) selon l'une quelconque des revendications 9 ou 10, dans laquelle la première couche (102, 202, 302) est prévue directement sur la lame de rasoir (10, 20, 30) ;
ou dans laquelle le revêtement dur (208, 308) est prévu directement sur la lame de rasoir (10, 20, 30) ;
ou dans laquelle une couche intermédiaire est prévue sur la lame de rasoir (10, 20, 30) et le revêtement dur (208, 308) est prévu sur la couche intermédiaire, plus préférablement dans laquelle la couche intermédiaire comprend du niobium ou du titane, et en particulier dans laquelle la couche intermédiaire comprend du titane métallique.

**12.** Lame de rasoir (10, 20, 30) selon l'une quelconque revendication précédente, dans laquelle la lame de rasoir (10, 20, 30) comprend, consiste essentiellement ou est constituée d'un métal, en particulier d'un acier inoxydable.

**13.** Cartouche de rasoir comprenant au moins une lame de rasoir (10, 20, 30) selon l'une quelconque revendication précédente.

**14.** Procédé permettant de revêtir une lame de rasoir (10, 20, 30), dans lequel le procédé est **caractérisé en ce qu'**il comprend :

- le revêtement d'une lame de rasoir (10, 20, 30) avec une première couche (102, 202, 302) comprenant du titane, plus préférablement par dépôt physique en phase vapeur, et
- le revêtement de la lame de rasoir (10, 20, 30) avec une seconde couche (104, 204, 304a et 304b) comprenant un parylène, plus préférablement par dépôt chimique en phase vapeur.

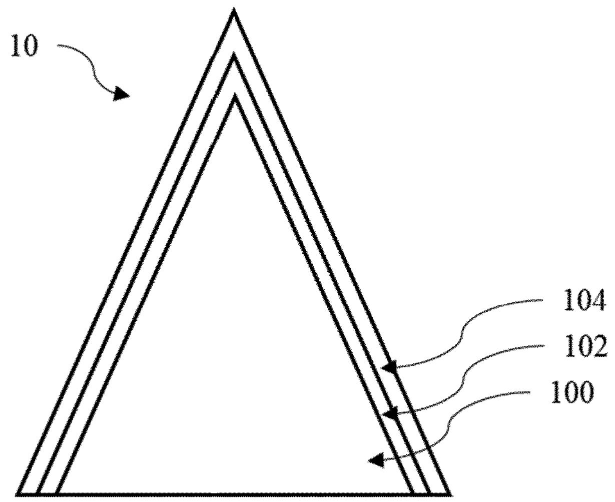


**Figure 1**

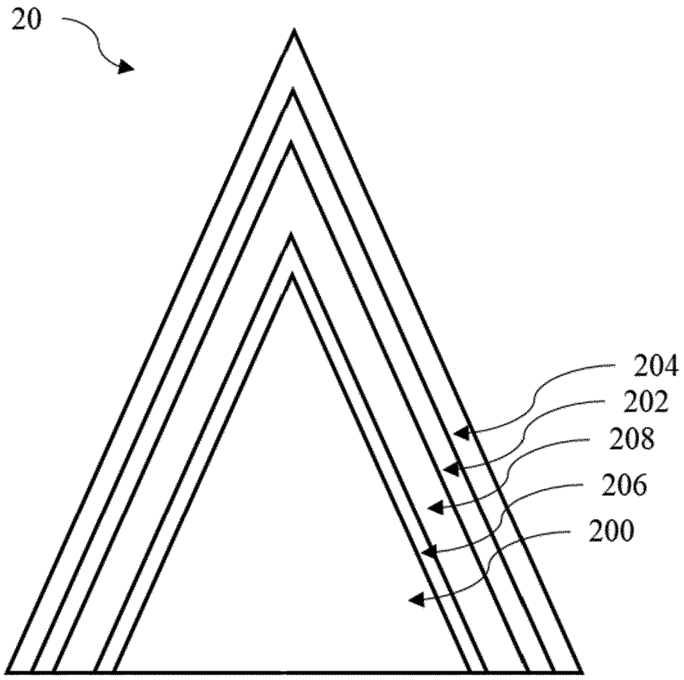


**Figure 2**

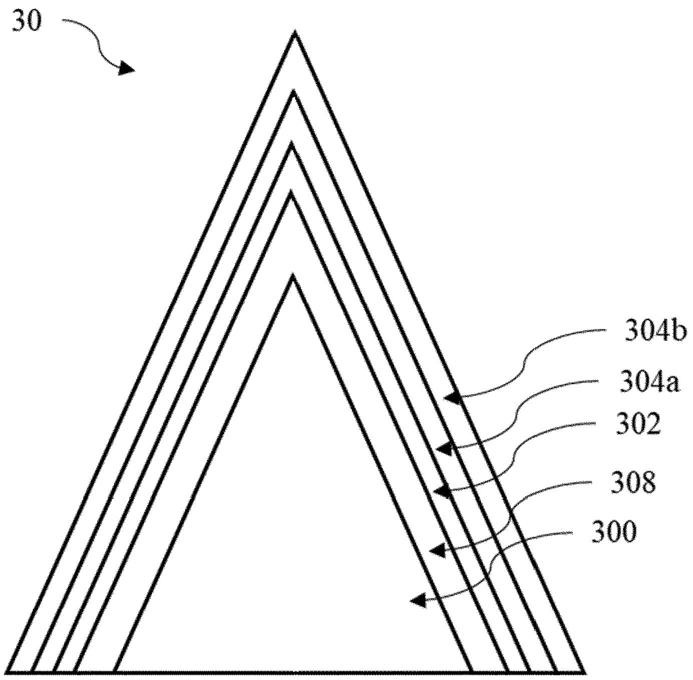


Figure 3

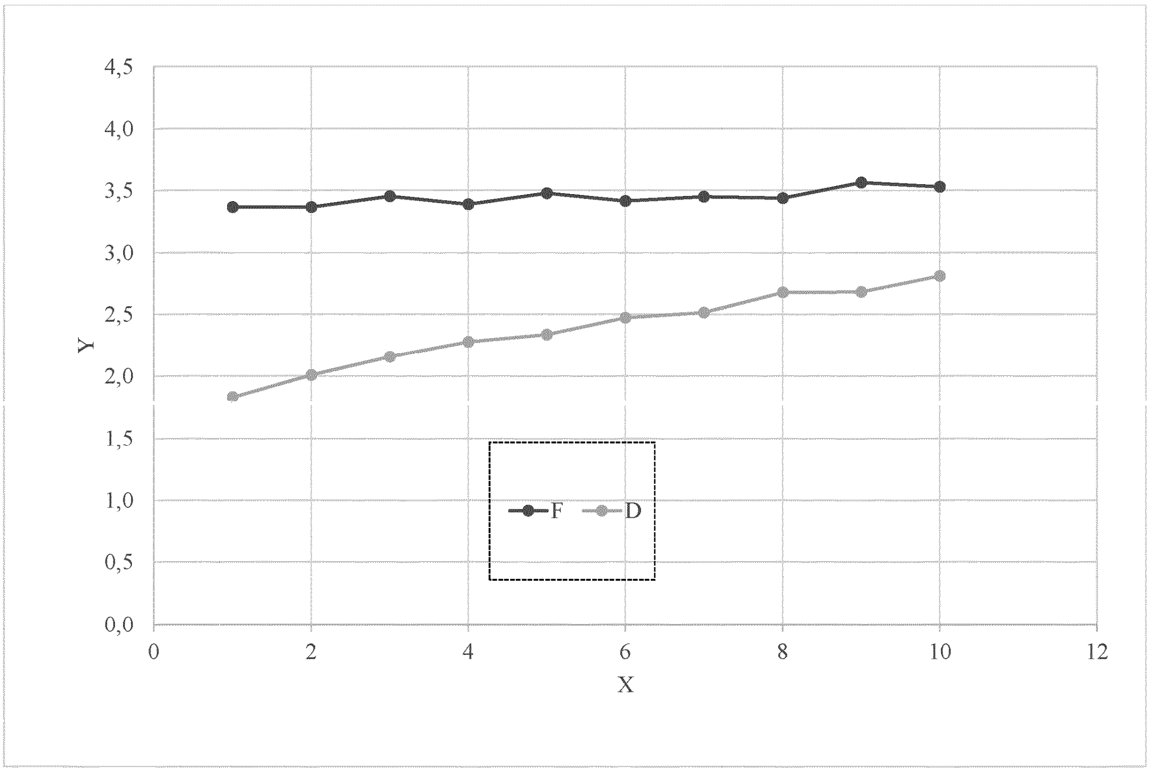


Figure 4

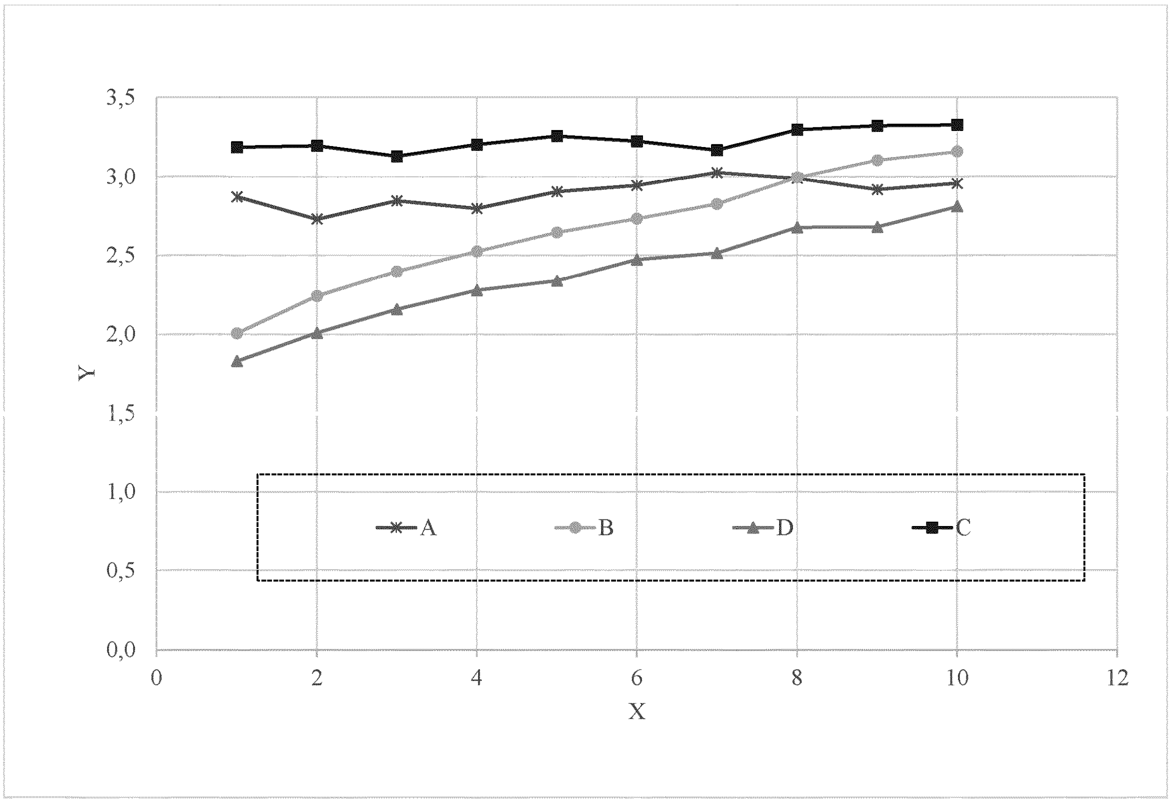


**Figure 5**

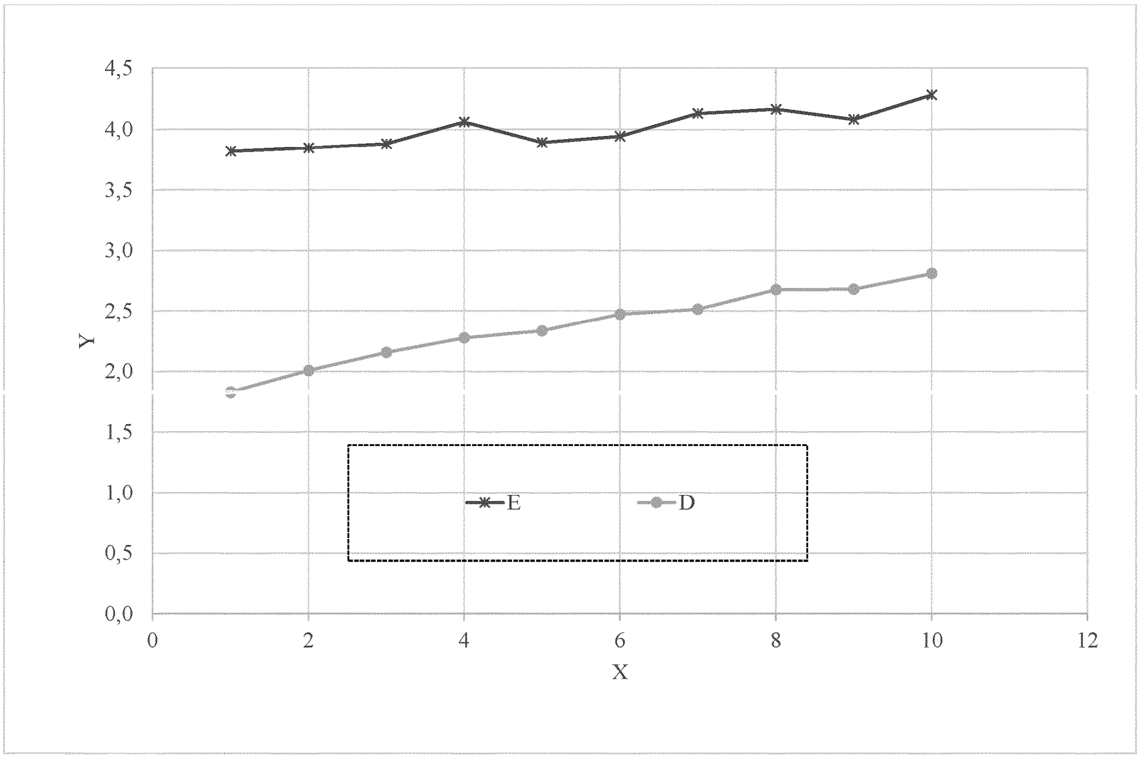


Figure 6

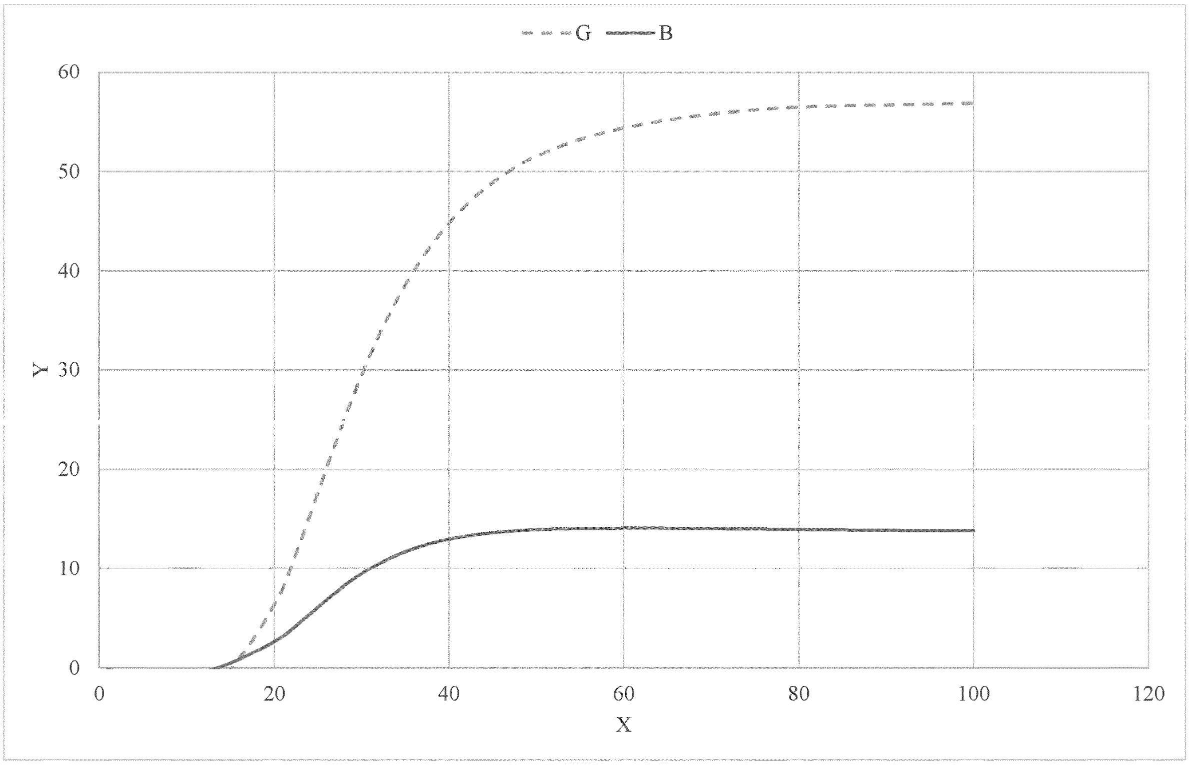


Figure 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020316803 A
- US 2017113359 A
- US 4950365 A
- US 2023066180 A
- US 5869135 A
- US 2017136641 A1
- US 2018215056 A1
- US 10442098 B2